# EUROPÄISCHE PATENTSCHRIFT

(11) **EP 2 228 806 B1**
(45) Veröffentlichungstag und Bekanntmachung des Hinweises auf die Patenterteilung: **03.08.2011**
(21) Anmeldenummer: 09290181.8
(22) Anmeldetag: 13.03.2009
(51) Int. Cl.: H01B 12/06, H01L 39/16

(54) **Anordnung zur Strombegrenzung**
Current limiter
Limiteur de courant

(43) Veröffentlichungstag der Anmeldung: 15.09.2010
(73) Patentinhaber: Nexans, 75008 Paris (FR)
(72) Erfinder: Stemmle, Mark, 30161 Hannover (DE); Soika, Rainer, 30559 Hannover (DE)
(74) Vertreter: Döring, Roger

(56) Entgegenhaltungen:
- EP-A- 1 681 731
- US-A1- 2003 183 410
- US-A1- 2008 194 411

## Beschreibung

Die Erfindung bezieht sich auf eine Anordnung zur Strombegrenzung, gemäβ dem Oberbegriff des Patentanspruchs 1, Eine solche Anordnung geht aus der US 2008/0194411 A1 hervor. Supraleitfähige Materialien werden beispielsweise als Leiter in der Stromübertragung dienenden Kabeln eingesetzt. Das supraleitfähige Material besteht in heutiger Technik aus einem Verbundwerkstoff, welcher keramisches Material enthält, das bei ausreichend tiefen Temperaturen in den supraleitfähigen Zustand übergeht. Der elektrische Gleichstromwiderstand eines entsprechend aufgebauten Leiters ist bei ausreichender Kühlung Null, solange eine bestimmte Stromstärke, die kritische Stromstärke, nicht überschritten wird. Geeignete keramische Materialien sind beispielsweise oxidische Materilien auf Basis seltener Erden (ReBCO), insbesondere YBCO (Yttrium-Barium-Kupfer-Oxid), oder BSCCO (Wismut-Strontium-Kalzium-Kupfer-Oxid). Ausreichend niedrige Temperaturen, um ein derartiges Material in den supraleitfähigen Zustand zu bringen, liegen beispielsweise zwischen 67 K und 110 K. Geeignete Kühlmittel sind beispielsweise Stickstoff, Helium, Neon und Wasserstoff oder Gemische dieser Stoffe.

Eine Anordnung zur Strombegrenzung, wie sie eingangs beschrieben ist, kann als eine Art Sicherung in eine beliebige Übertragungsstrecke, wie eine Kabelstrecke oder auch eine Schaltanlage, eingebaut werden, über die bzw. in der mehr oder weniger hohe Ströme übertragen werden. Sie soll verhindern, daß bei einem Kurzschluß, der auf die zu schützende Übertragungsstrecke wirkt, wesentliche Beschädigungen derselben eintreten. Im Kurzschlußfall steigt die elektrische Impedanz der Anordnung erheblich an, so daß bereits der Stoßkurzschlußstrom stark vermindert wird. Durch einen Leistungsschalter kann die Übertragungsstrecke dann unterbrochen werden, um den Kurzschluß zu beseitigen. Die Übertragungsstrecke kann nach Behebung der Ursache des Kurzschlusses wieder zugeschaltet werden, ohne daß an der strombegrenzenden Anordnung etwas geändert werden muß.

Die EP 1 681 731 A1 beschreibt eine Anordnung mit mindestens einer supraleitfähigen Komponente zur Strombegrenzung. Die Komponente besteht aus einem zylindrischen Träger aus supraieitfahigem Material, um den ein supraleitfähiger Leiter herumgewickelt ist. Parallel zu demselben ist ein Normalleiter geschaltet. Mehrere solcher Komponenten werden zur Herstellung eines Strombegrenzers elektrisch in einer Reihen- oder Parallelschaltung angeordnet.

Aus der eingangs erwähnten US 2008/0194411 A1 geht eine Anordnung zur Strombegrenzung hervor, in der eine Komponente oder mehr Komponenten aus supraleitfähigem Material auf der Basis seltener Erden, wie beispielsweise Yttrium-Barium-Kupfer-Oxid, eingesetzt sein können. Jede der Komponenten besteht aus drei koaxial zueinander angeordneten, durch Isoliermaterial voneinander getrennten Phasenleitern, die von einem Kryostat umgeben sind.

Der Erfindung liegt die Aufgabe zugrunde, die eingangs geschilderte Anordnung einfacher zu gestalten, und eine besondere gleichmäßige Inspectanz zu erzielen.

Diese Aufgabe wird entsprechend dem kennzeichnenden Merkmal des Patentanspruchs 1 gelöst.

Das ReBCO-Material Ist ein suprateitfähiges Material der sogenannten zweiten Generation. Leiter aus ReBCO-Material haben gegenüber Leitern aus Material der ersten Generation, beispielsweise BSCCO, im Bereich der Normalleitung einen wesentlich niedrigeren elektrischen Widerstand. Die Phasenleiter der Komponenten werden zweckmäßig so ausgelegt, daß ihre kritische Stromstärke der Amplitude der

Stromstärke entspricht, ab der eine Kurzschlußstrornbegrenzung einsetzen soll. Das supraleitfähige Material der Phasenleiter geht bei Erreichen dieser Stromstärke in den normalleitenden Zustand über. In diesem Zustand ist das ReBCO-Material elektrisch schlecht leitend, so daß direkt eine wesentliche Erhöhung des Widerstandes der Phasenleiter bewirkt wird, also eine Erhöhung der elektrischen Impedanz der Komponenten. Der über die Anordnung fließende Kurzschlußstrom wird damit merklich und schnell begrenzt. Der durch den Kurzschlußstrom bedingte Energieeintrag in die Komponenten führt zu einer Erwärmung derselben. Nach erfolgter Begrenzung des Kurzschlußstroms wird die Anordnung daher zweckmäßig von der Übertragungsstrecke getrennt, um eine schnelle Rückkühlung der Komponenten zu ermöglichen. Es ist dadurch sichergestellt, daß die Anordnung durch einen Kurzschlußstrom nicht beschädigt wird. Sie ist nach einer kurzen Rückkühlzeit und nach der Beseitigung der Ursache des Kurzschlusses auf der Übertragungsstrecke ohne irgendwelche Maßnahmen wieder funktionsfähig.

Wenn in bevorzugter Ausführungsform der Anordnung nur drei Komponenten des supraleitfähigen Kabels eingesetzt werden, dann werden für die Verbindung der Phasenleiter nur wenige Kontakte benötigt. Das vermindert die kontaktbedingten Verluste, insbesondere dann, wenn für die Verbindung der jeweiligen Phasenleiter supraleitfähige Leiter der ersten Generation verwendet werden, wie beispielsweise BSCCO-Leiter. Von besonderem Vorteil ist die zyklische Durchverbindung der drei unterschiedlichen Phasenleiter in den drei unterschiedlichen Komponenten der Anordnung, weil dadurch eine besonders gleichmäßige Impedanz der ganzen Anordnung erzielt wird. Eine Anordnung mit drei Komponenten ermöglicht auch einen sehr kompakten Aufbau derselben, mit einer relativ kleinen Oberfläche des Kryostats und entsprechend geringen thermischen Verlusten. Außerhalb der konzentrischen Anordnung der Phasenleiter in jeder Komponente treten im Normalbetrieb aufgrund der gegenseitigen Kompensation keine elektromagnetischen Felder auf. Daher können im Kryostaten keine Wirbelströme induziert werden, die ebenfalls zu Verlusten führen würden.

Ausführungsbeispiele des Erfindungsgegenstandes sind in den Zeichnungen dargestellt.

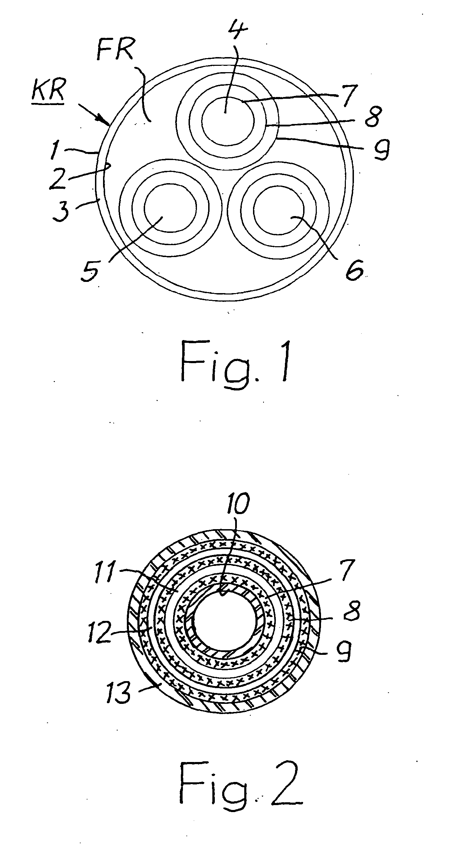

Es zeigen:
F ig. 1 in schematischer Darstellung eine Seitenansicht der Anordnung nach der Erfindung.
F ig. 2 eine Einzelheit der Anordnung nach Fig. 1 in vergrößerter Darstellung.
F ig. 3 eine gegenüber Fig. 1 abgewandelte Ausführungsform der Anordnung ebenfalls in schematischer Darstellung.
F ig. 4 ein Schema der elektrisch leitenden Verbindung zwischen Komponenten der Anordnung.

Die Anordnung nach der Erfindung wird im folgenden für drei (n = 3) Komponenten mit jeweils drei supraleitfähigen Phasenleitern erläutert. Es könnten bei entsprechender Bemessung auch zwei oder mehr Einheiten von je drei derartigen Komponenten in einem Kryostat untergebracht sein.

In Fig. 1 ist ein aus zwei koaxial zueinander angeordneten metallischen Rohren 1 und 2 bestehender Kryostat KR dargestellt. Zwischen den Rohren 1 und 2, die auch quer zu ihrer Längsrichtung gewellt sein können, befindet sich eine Vakuumisolierung 3. Der Kryostat KR umschließt einen Freiraum FR zum Durchleiten eines Kühlmittels, in dem drei Komponenten 4, 5 und 6 angeordnet sind, die jeweils drei gegeneinander isolierte, konzentrisch zueinander angeordnete Phasenleiter 7, 8 und 9 aufweisen.

Die supraleitfähigen Phasenleiter 7, 8 und 9 bestehen mit Vorteil aus Bändern aus ReBCO. und zwar vorzugsweise aus YBCO. Der innen liegende Phasenleiter 7 ist um einen Träger 10 herumgeformt, der im dargestellten Ausführungsbeispiel als Rohr ausgeführt ist, das mit Vorteil aus glasfaserverstärktem Kunststoff besteht. Als Träger 10 könnte auch ein Strang verwendet werden. Der Phasenleiter 7 ist mit Abstand konzentrisch vom mittleren Phasenleiter 8 umgeben, der seinerseits ebenfalls mit Abstand konzentrisch vom außen liegenden Phasenleiter 9 umgeben ist. Die konzentrischen Lücken zwischen den Phasenleitern sind eine Isolierschicht 11 zwischen den Phasenleitern 7 und 8 und eine Isolierschicht 12 zwischen den Phasenleitern 8 und 9.

Die Isolierschichten 11 und 12 sind mit Vorteil freie Spalte, durch welche beim Betrieb der Anordnung das durch den Kryostat geleitete Kühlmittel ebenso wie durch den Träger 10 hindurchtreten kann, wenn derselbe als Rohr ausgeführt ist. Das ermöglicht kürzere Rückkühlzeiten der Anordnung nach Beseitigung eines Kurzschlusses. Die freien Spalte zwischen den Phasenleitern können bei entsprechender Halterung derselben an ihren Enden ohne weitere Hilfsmittel eingehalten werden. Es können aber auch an wenigen Stellen im Verlauf der Phasenleiter materialarme Abstandshalter aus Isoliermaterial zwischen den Phasenleitern angebracht werden, durch welche der Durchtritt des Kühlmittels zwischen den Phasenleitern kaum behindert wird. Es ist auch möglich, als Isolierschichten 11 und 12 Rohre aus Isoliermaterial einzusetzen, beispielsweise aus glasfaserverstärktem Kunststoff.

Die drei Komponenten 4, 5 und 6 können bei der Ausführurigsform nach Fig. 1 so im Kryostat KR angeordnet sein, daß sie einander nicht berühren, sondern beim Betrieb der Anordnung vom Kühlmittel umspült werden. Über dem außen liegenden Phasenleiter 9 der Komponenten 4, 5 und 6 kann aber auch eine in Fig. 2 eingezeichnete Isolierschicht 13 angebracht sein.

Die Phasenleiter 7,8 und 9 bestehen mit Vorteil aus YBCO-Material tragenden Bändern, die in mindestens zwei Lagen um ihre jeweilige Unterlage herumgewickelt sind. Die aus den Bändern bestehenden Lagen sind voneinander isoliert. In den einzelnen Lagen sind mehrere Bänder nebeneinander angeordnet, ebenfalls voneinander isoliert und elektrisch parallel geschaltet. Zur Erzielung einer möglichst großen Länge an YBCO-Material sind die Bänder mit Vorteil mit kurzem Schlag aufgewickelt. Die Wickelrichtung der einzelnen Lagen kann vorzugsweise gegenläufig sein. Statt der Bänder können auch YBCO-Material tragende Drähte eingesetzt werden. Die Schlaglängen und Schlagrichtungen der Bänder werden so gewählt, daß die Phasenleiter 7, 8 und 9 eine möglichst geringe Induktivität haben.

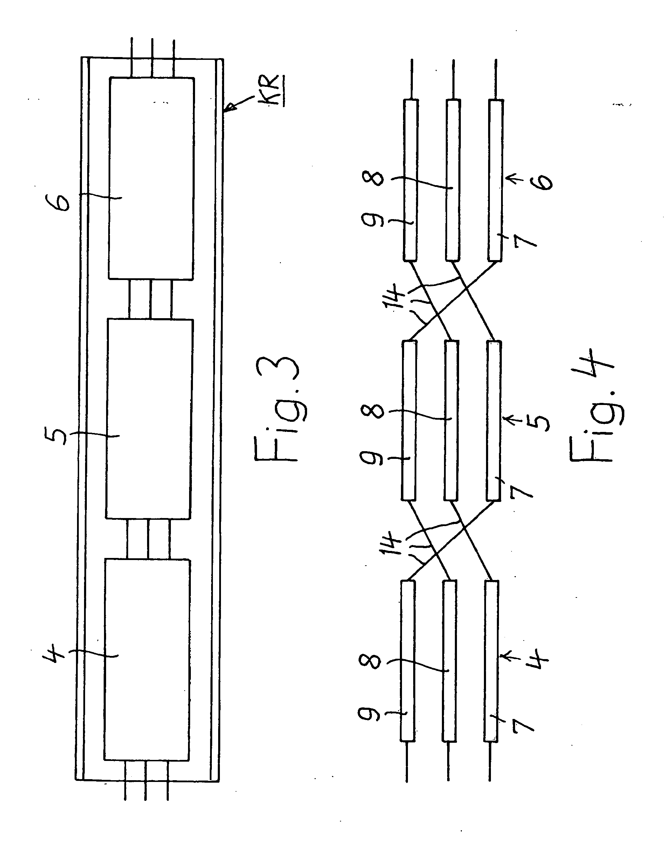

Gemäß Fig. 1 sind die Komponenten 4, 5 und 6 nebeneinander im Kryostat KR angeordnet. Das ermöglicht einen axial kurzen, kompakten Aufbau der Anordnung. Die Komponenten 4, 5 und 6 können gemäß Fig. 3 aber auch hintereinander im Kryostat KR angebracht sein, so daß dessen Durchmesser verringert werden kann. In beiden Ausführungsformen hat der Kryostat eine relativ kleine äußere Oberfläche, mit entsprechend geringen thermischen Verlusten.

Die Phasenleiter 7, 8 und 9 der drei Komponenten 4, 5 und 6 sind elektrisch leitend miteinander verbunden. Dazu werden mit Vorteil Verbindungsleiter 14 aus BSCCO eingesetzt. Die Verbindung erfolgt gemäß Fig. 4 zyklisch mit Platztausch, so daß jeder Phasenleiter der Anordnung jede der drei möglichen Positionen einnimmt.

In diesem Sinne wird beispielsweise der äußere Phasenleiter 9 der Komponente 4 mit dem inneren Phasenleiter 7 der Komponente 5 und weiterführend mit dem mittleren Phasenleiter 8 der Komponente 6 verbunden. Der mittlere Phasenleiter 8 der Komponente 4 wird mit dem äußeren Phasenleiter 9 der Komponente 5 und weiterführend mit dem inneren Phasenleiter 7 der Komponente 6 verbunden. Ebenso wird der innere Phasenleiter 7 der Komponente 4 mit dem mittleren Phasenleiter 8 der Komponente 5 und weiterführend mit dem äußeren Phasenleiter 9 der Komponente 6 verbunden. Die entsprechenden Verbindungsleiter 14 sind in Fig. 4 als sich kreuzende Linien eingezeichnet.

Die so fertiggestellte Anordnung wird im Einsatzfall in eine Übertragungsstrecke für elektrischen Strom eingeschaltet. Die Komponenten 4, 5 und 6 sind dann Teil dieser Übertragungsstrecke. Durch einen im Energieversorgungsnetz auftretenden Kurzschluß fließt über die Übertragungsstrecke ein Strom mit erhöhter Stromstärke. Wenn diese höher als die kritische Stromstärke der Phasenleiter 7, 8 und 9 der Komponenten 4, 5 und 6 ist, wird deren elektrischer Widerstand schlagartig wesentlich erhöht, was eine schlagartige Erhöhung der elektrischen Impedanz der Anordnung zur Folge hat. Das wird in einer entsprechenden Überwachungsschaltung registriert und führt zu einer Abschaltung der Übertragungsstrecke. Dadurch können die Komponenten 4, 5 und 6 sofort zurückgekühlt werden. Sobald die Ursache für den Kurzschluß dann beseitigt ist, kann die Übertragungsstrecke wieder zugeschaltet werden.

## Patentansprüche

1. Anordnung zur Strombegrenzung, unter Verwendung von Komponenten (4,5,6), die aus jeweils drei Phasenleitern (7,8,9) aus einem supraleitfähigen Material auf Basis seltener Erden (ReBCO) bestehen, welche gegeneinander isoliert konzentrisch zueinander angeordnet sind, und eines Kryostats (KR), der aus zwei konzentrisch zueinander angeordneten, metallischen Rohren (1,2) besteht, zwischen denen eine Vakuumisolierung (3) angebracht ist, und der einen Freiraum (FR) zum Durchleiten eines Kühlmittels umschließt, **dadurch gekennzeichnet, daß** in dem Kryostat (KR) "n" Komponenten (4,5,6) angeordnet sind, deren Phasenleiter zyklisch derart elektrisch leitend miteinander verbunden sind, daß der innen liegende Phasenleiter (7) jeder Komponente mit dem mittleren Phasenleiter (8) einer zweiten Komponente und dieser mittlere Phasenleiter (8) mit dem außen liegenden Phasenleiter (9) der dritten Komponente verbunden ist, mit n = 3 oder ein ganzzahliges Vielfaches von 3.

2. Anordnung nach Anspruch 1, **dadurch gekennzeichnet, daß** die Phasenleiter (7,8,9) aus das supraleitfähige Material tragenden, voneinander isolierten Bändern bestehen, die in mindestens zwei voneinander isolierten, übereinander angeordneten Lagen um einen Träger herumgewickelt sind, vorzugsweise mit einer kurzen Schlaglänge.

3. Anordnung nach Anspruch 2, **dadurch gekennzeichnet, daß** die Schlaglänge und die Schlagrichtung der Bänder so bemessen sind, daß die Phasenleiter (7,8,9) eine möglichst geringe Induktivität haben.

4. Anordnung nach Anspruch 2 oder 3, **dadurch gekennzeichnet, daß** die Bänder der einzelnen Lagen elektrisch parallel geschaltet sind.

5. Anordnung nach einem der Ansprüche 1 bis 4, **dadurch gekennzeichnet, daß** die Komponenten (4,5,6) räumlich nebeneinander angeordnet sind.

6. Anordnung nach einem der Ansprüche 1 bis 4, **dadurch gekennzeichnet, daß** die Komponenten (4,5,6) räumlich axial hintereinander angeordnet sind.

7. Anordnung nach einem der Ansprüche 1 bis 6, **dadurch gekennzeichnet, daß** die Phasenleiter (7,8,9) aus YBCO bestehen.

8. Anordnung nach einem der Ansprüche 1 bis 7, **dadurch gekennzeichnet, daß** als Verbindungsleiter (14) zwischen den Phasenleitern (7,8,9) der Komponenten (4,5,6) supraleitfähige Leiter aus BSCCO eingesetzt sind.

## Claims

1. Arrangement for current limiting, using components (4,5,6) each comprising three phase conductors (7,8,9) composed of a superconducting material based on rare earths (ReBCO), which are arranged insulated from one another and concentric ally with respect to one anther and a cryostat (KR) which comprises two metallic tubes (1,2) which are arranged concentrically with respect to one another and between which a vacuum insulation (3) is provided, and which cryostat surrounds a free space (FR) for a coolant to pass through, **characterized in that** "n" components (4,5,6) are arranged in the cryostat (KR), the phase conductors of which are cyclically electrically conductively connected to one another such that the inner phase conductor (7) of each component is connected to the centre phase conductor(8) of a second component, and this centre phase conductor(8) isconnected to the outerphase conductor(9) of the third component, where n = 3 oran integermultiple of 3.

2. Arrangement according to claim 1, **characterized in that** the phase conductor (7,8,9) comprise ribbons which support the superconducting material, are insulated from one another and are wound around a support in at least two layers, which are insulated from one another and are arranged one above the other, preferably with a short length oflay.

3. Arrangement according to claim 2, **characterized in that** the length of lay and the direction of lay of the ribbons are designed such that the phase conductor (7, 8, 9) have an inductance as small as possible.

4. Arrangement according to claim 2 o r 3, **characterized in that** the ribbons of the individual layers are electrically connected in parallel.

5. Arrangement according to one of the claims 1 to 4, **characterized in that** the components (4, 5, 6) are arranged physically side by side.

6. Arrangement according to one of the claims 1 to 4, **characterized in that** the components (4, 5, 6) are arranged physically axially one behind the other.

7. Arrangement according to one of the claims 1 to 6, **characterized in that** the phase conductors (7,8,9) consist of YBCO.

8. Arrangement according to one of the claims 1 to 7, **characterized in that** superconducting conductors consisting of BSCCO are used as connecting conductors (14) between the phase conductors (7, 8, 9) of the components (4, 5, 6).

## Revendications

1. Système de limitation du courant qui recourt à des composants (4, 5, 6) constitués chaque fois de trois conducteurs de phase (7, 8, 9) en un matériau supraconducteur à base de terres rares (ReBCO) qui sont disposés concentriquement les uns par rapport aux autres et qui sont isolés les uns par rapport aux autres, et à un cryostat (KR) constitué de deux tubes métalliques (1, 2) disposés concentriquement l'un par rapport à l'autre et entre lesquels est placée une isolation (3) sous vide, le cryostat entourant un espace libre (FR) permettant le passage d'un fluide de refroidissement, **caractérisé en ce que**
- "n" composants (4, 5, 6) dont les conducteurs de phase sont reliés cycliquement les uns aux autres de manière électriquement conductrice sont disposés dans le cryostat (KR) et
- **en ce que** le conducteur de phase (7) situé à l'intérieur de chaque composant est relié au conducteur de phase (8) central d'un deuxième composant et ce conducteur de phase central (8) est relié au conducteur de phase (9) situé à l'extérieur du troisième composant, avec n = 3 ou un multiple entier de 3.

2. Système selon la revendication 1, **caractérisé en ce que** les conducteurs de phase (7, 8, 9) sont constitués de rubans portant un matériau supraconducteur, isolés les uns des autres et enroulés autour d'un support en au moins deux couches isolées l'une de l'autre et disposées l'une au-dessus de l'autre, de préférence à un petit pas d'enroulement.

3. Système selon la revendication 2, **caractérisé en ce que** le pas d'enroulement et la direction d'enroulement des rubans sont dimensionnés de telle sorte que les conducteurs de phase (7, 8, 9) présentent une inductance aussi petite que possible.

4. Système selon la revendication 2 ou 3, **caractérisé en ce que** les rubans des différentes couches sont raccordés électriquement en parallèle.

5. Système selon l'une des revendications 1 à 4, **caractérisé en ce que** les composants (4, 5, 6) sont disposés spatialement les uns à côté des autres.

6. Système selon l'une des revendications 1 à 4, **caractérisé en ce que** les composants (4, 5, 6) sont disposés spatialement les uns derrière les autres dans la direction axiale.

7. Système selon l'une des revendications 1 à 6, **caractérisé en ce que** les conducteurs de **phase** (7, 8, 9) sont constitués d'YBCO.

8. Système selon l'une des revendications 1 à 7, **caractérisé en ce qu'**il utilise des conducteurs supraconducteurs en BSCCO comme conducteurs de liaison (14) entre les conducteurs de phase (7, 8, 9) des composants (4, 5, 6).
